# FASCICULE DE BREVET EUROPEEN

(11) **EP 1 939 888 B1**
(45) Date de publication et mention de la délivrance du brevet: **15.09.2010**
(21) Numéro de dépôt: 07123410.8
(22) Date de dépôt: 17.12.2007
(51) Int. Cl.: G11C 11/412, H01L 27/11

(54) **Cellule mémoire dotée de transistors double-grille, à grilles indépendantes et asymétriques**
Speicherzelle ausgestattet mit Transistoren mit Doppel-Gate, unabhängigen und asymmetrischen Gates
Memory cell equipped with double-gate transistors, with independent and asymmetric gates

(30) Priorité: 28.12.2006 FR 0656014
(43) Date de publication de la demande: 02.07.2008
(73) Titulaire: Commissariat à l'Énergie Atomique et aux Énergies Alternatives, 75015 Paris (FR)
(72) Inventeur: Thomas, Olivier, 38420 Revel (FR); Vinet, Maud, 38140 Rives (FR)
(74) Mandataire: Ilgart, Jean-Christophe

(56) Documents cités:
- US-A1- 2004 155 281
- US-A1- 2006 274 569
- US-B2- 6 798 682

## Description

### DOMAINE TECHNIQUE

L'invention se rapporte au domaine des mémoires, et notamment à celui des mémoires statiques à accès aléatoires SRAM (RAM pour « random access memory »). L'invention concerne une structure de cellule mémoire améliorée, doté de transistors double-grille et comprenant des transistors à double-grilles asymétriques et des transistors à double-grille symétriques.

### ART ANTÉRIEUR

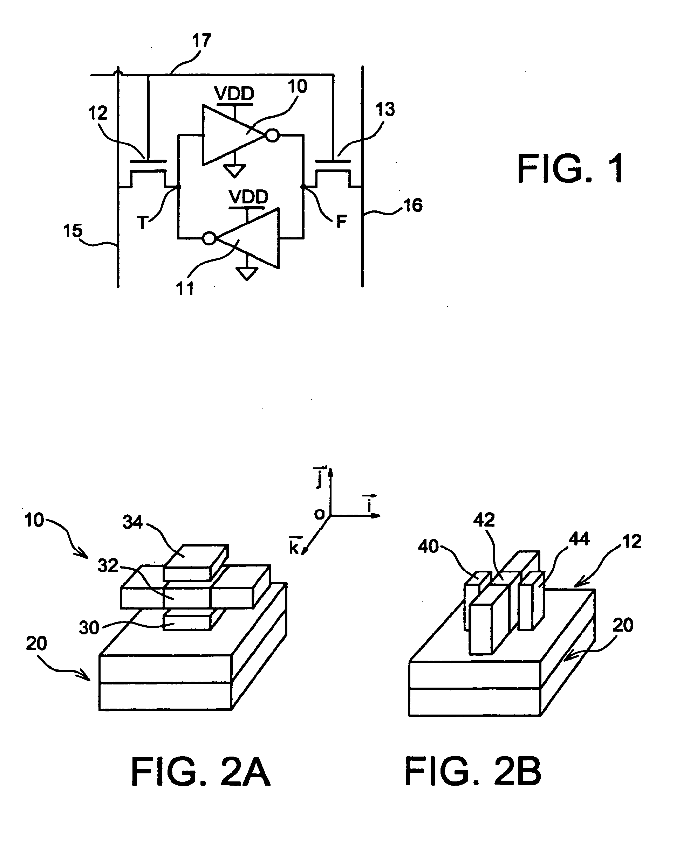

Une cellule mémoire SRAM classique (SRAM pour « static random access memory » ou mémoire vive statique) comprend généralement deux inverseurs 10, 11, connectés selon une configuration dite « de bascule » ou « flip-flop » et deux transistors d'accès 12, 13 connectés à des lignes dites de bit 15 et 16, et commandés par une ligne de mot 17 (figure 1).

Les caractéristiques recherchées pour une cellule mémoire sont :
- une bonne stabilité lors des différentes opérations de lecture, d'écriture, de rétention, effectuées sur la cellule,
- un courant de conduction ou de charge le plus important possible pour donner à la cellule une vitesse de fonctionnement élevée,
- une taille de cellule la plus faible possible pour permettre de réaliser une mémoire avec une densité d'intégration de cellules importante,
- un courant en rétention le plus faible possible afin de minimiser la puissance consommée statique.

Ces critères sont contradictoires entre eux et amènent les concepteurs de mémoires à faire des compromis.

Les cellules SRAM à six transistors appelées cellules « 6T », offrent un bon compromis entre tous les critères précités. Des cellules mémoires SRAM dites « 4T », à quatre transistors ont également été développées. Les cellules 4T ont un encombrement réduit et permettent d'obtenir une forte densité d'intégration.

Cependant, en cherchant à réduire de plus en plus les tailles des transistors des cellules mémoires, les paramètres de ces transistors tels que leur largeur W de canal, leur longueur L de canal, leur tension de seuil V_{T}, leur perméabilité µ₀, leur dopage Na, leur épaisseur d'oxyde de grille Tox, fluctuent. Cela entraîne, comme indiqué dans les documents [TAK01] et [YAM04] (référencés à la fin de la présente description au même titre que tous les autres documents cités dans la présente demande), une augmentation de la sensibilité des cellules mémoires face aux différentes sources de bruit telles que le couplage capacitif, le couplage inductif, le bruit d'alimentation. Le développement d'une cellule mémoire présentant une marge au bruit élevée devient donc de plus en plus une priorité.

Pour les cellules mémoire 6T conventionnelles, la stabilité des cellules est déterminée par leur marge au bruit statique (SNM) en mode lecture. En effet, lors d'un accès en lecture, le gain des inverseurs de la cellule a tendance à être diminué par la mise en conduction des transistors d'accès.

Pour annuler cet effet, une cellule à 10 transistors pour laquelle, lors d'un cycle de lecture, les noeuds de stockage et les lignes de bit sont découplés, a été proposée dans le document [CHA01].

Une cellule mémoire à 8 transistors réalisée en technologie double grille ayant un fonctionnement similaire à celle comportant 10 transistors évoquée précédemment, a quant à elle été divulguée dans le document [KIM05]. Malgré une forte amélioration de la marge au bruit statique SNM, les cellules à 10 transistors et à 8 transistors, ont un encombrement important par rapport aux cellules 6T.

Les cellules 4T ont quant à elles pour inconvénient d'avoir un manque de stabilité en mode de rétention. Ce manque de stabilité peut être pallié par un système de rafraîchissement. Les documents [CEA03], [YAM04], [MOS02], [TI02] présentent différents dispositifs de cellules 4T dépourvus de système de rafraîchissement.

Ces cellules sont limitées à une réalisation dans une technologie donnée et nécessitent des modes opératoires spécifiques, par exemple un mode opératoire avec une tension d'alimentation inférieure à 0,5 V et/ou une régulation de température.

Typiquement, le dimensionnement des cellules 4T, est réalisé en tenant compte du meilleur compromis qui peut être atteint entre la stabilité en phase de rétention et la stabilité en phase de lecture. Plusieurs solutions ont été présentées pour améliorer le rapport de ces stabilités.

Le document [TI02] présente par exemple un dispositif microélectronique de mémoire vive statique doté de cellules 4T réalisées sur un substrat massif communément appelé « Bulk » (selon la terminologie anglo-saxonne), dans lequel la tension de la ligne de mot est réduite, afin d'augmenter la marge au bruit statique. Les cellules 4T divulguées dans ce document présentent cependant un courant de conduction faible.

Dans le document [MOS02], des moyens de contrôle du potentiel du substrat des transistors de charge sont prévus afin d'améliorer la stabilité en rétention de la cellule. Cette solution peut permettre également de mettre en oeuvre une cellule avec des transistors de taille très faible, par exemple ayant une longueur de canal de l'ordre de 0,18 µm. Cependant, la mise en oeuvre de ces moyens de contrôle est contraignante.

Dans le document [CEA03], la réalisation d'une cellule appelée « 4T-SR » en technologie SOI partiellement déserté (SOI pour « silicon on insulator » ou « silicium sur isolant ») est présentée. Cette cellule est caractérisée par une autorégulation des charges des noeuds de stockage et permet de maintenir une information stockée sans faire appel à un circuit de rafraîchissement. Un inconvénient de cette cellule est qu'elle est spécifique à la technologie SOI partiellement déserté (SOI pour « Silicon On Insulator » ou « silicium sur isolant ») et qu'elle nécessite une tension d'alimentation inférieure à 0,5V.

Une cellule 4T réalisée en technologie SOI totalement désertée (FD) dotée d'une boucle de contre réaction, a quant à elle été divulguée dans le document [YAM04]. Cette boucle permet de contrôler le substrat actif des transistors pour moduler dynamiquement leur tension de seuil.

Le document US 2004/155281 A1 concerne une cellule de mémoire SRAM suivant l'art antérieur comprenant une première pluralité de transistors formant une bascule, un premier transistor d'accès et un deuxième transistor d'accès disposés respectivement entre une première ligne de bit et un premier noeud de stockage, et entre une deuxième ligne de bit et un deuxième noeud de stockage, les transistors d'accès comportant une électrode de grille connectée à l'électrode de substrat.

Il se pose le problème de trouver une nouvelle structure de cellule mémoire SRAM, présentant d'une part une stabilité et une marge au bruit statique améliorées, tout en conservant un encombrement satisfaisant et éventuellement amélioré.

Il de pose le problème de trouver une nouvelle structure de cellule mémoire SRAM en technologie Double grille, présentant d'une part une bonne stabilité en rétention, en lecture et en écriture, tout en conservant un encombrement satisfaisant et éventuellement amélioré.

### EXPOSÉ DE L'INVENTION

L'invention concerne tout d'abord une cellule de mémoire vive à accès aléatoire, comprenant :
- au moins une première pluralité de transistors à double-grille symétrique formant une bascule,
- au moins un premier transistor d'accès à double-grille et au moins un deuxième transistor d'accès à double-grille disposés respectivement entre une première ligne de bit et un premier noeud de stockage, et entre une deuxième ligne de bit et un deuxième noeud de stockage, une première grille du premier transistor d'accès et une première grille du deuxième transistor d'accès étant reliées à une première ligne de mot apte à acheminer un signal de polarisation, une seconde grille du premier transistor d'accès étant reliée au deuxième noeud de stockage et une seconde grille du deuxième transistor d'accès étant reliée au premier noeud de stockage, le premier transistor d'accès et le deuxième transistor d'accès étant dotés d'une double-grille asymétrique.

Une telle structure de cellule mémoire comporte à la fois des transistors à double-grille symétrique et des transistors à double-grille asymétrique.

La mise en oeuvre de transistors à double grille symétrique pour former la bascule, permet de limiter les courants de fuites et de limiter la consommation.

La mise en oeuvre de transistors à double grille asymétrique pour former les transistors d'accès, permet de moduler les courants de fuite et de conduction pour augmenter la stabilité en lecture et en rétention.

Une telle cellule présente d'une part une stabilité et une marge au bruit statique améliorées, ainsi qu'un encombrement réduit par rapport à une cellule 6T suivant l'art antérieur.

Selon une possibilité de mise en oeuvre, ladite première pluralité de transistors peut être formée :
- d'un premier transistor de charge à double-grille symétrique et d'un deuxième transistor de charge à double-grille symétrique, les deux grilles du premier transistor de charge étant connectées ensemble, les deux grilles du deuxième transistor de charge étant également connectées ensemble,
   ou
- d'un premier transistor de conduction à double-grille symétrique, et d'un deuxième transistor de conduction à double-grille symétrique, les deux grilles du premier transistor de conduction étant connectées ensemble, les deux grilles du deuxième transistor de conduction étant également connectées ensemble.

Un mode de réalisation de l'invention prévoit une cellule mémoire dotée de 4 transistors.

Selon un autre mode de réalisation, la cellule de mémoire vive à accès aléatoire, peut comprendre en outre :
- au moins une deuxième ligne de mot,
- au moins une troisième et une quatrième lignes de bit,
- au moins un troisième et un quatrième transistors d'accès à double-grille, connectés respectivement à la troisième ligne de bit et à la quatrième ligne de bit.
- Le troisième transistor d'accès et le quatrième transistor d'accès peuvent être dotés d'une double-grille asymétrique.

Selon l'autre mode de réalisation, la cellule peut être agencée de sorte qu'une première grille du troisième transistor d'accès et une première grille du quatrième transistor d'accès sont reliées à la deuxième ligne de mot apte à acheminer un signal de polarisation, une seconde grille du troisième transistor d'accès étant reliée au deuxième noeud de stockage et une seconde grille du quatrième transistor d'accès étant reliée au premier noeud de stockage.

Une cellule mémoire dotée de 6 transistors et agencée selon cet autre mode, peut être également prévue.

Selon une possibilité de mise en oeuvre, la cellule de mémoire vive à accès aléatoire, dans laquelle les deux grilles du troisième transistor d'accès ou/et du quatrième transistor d'accès sont connectées à la deuxième ligne de mot, la cellule peut comprendre en outre :
- au moins un transistor double-grille supplémentaire entre le troisième transistor d'accès et le premier noeud, les deux grilles du transistor supplémentaire étant reliées entre elles,
- au moins un autre transistor double-grille supplémentaire entre le quatrième transistor d'accès et le deuxième noeud, les deux grilles du transistor supplémentaire étant reliées entre elles.

Les transistors supplémentaires peuvent être dotés chacun d'une double-grille symétrique.

Selon une première possibilité, lesdites double-grilles asymétriques peuvent être de type « planaire » formées d'au moins un premier bloc de grille et d'au moins un deuxième bloc de grille de part et d'autre d'une zone semi-conductrice active, le premier bloc de grille, la zone semi-conductrice active, le deuxième bloc de grille étant superposés sur un substrat.

Selon une deuxième possibilité, les transistors de la mémoire peuvent être de type finFET, lesdites double-grilles asymétriques étant formées d'au moins un premier bloc de grille et d'au moins un deuxième bloc de grille de part et d'autre d'une zone semi-conductrice active, le premier bloc de grille zone semi-conductrice active, le deuxième bloc de grille étant juxtaposés sur un substrat.

La dissymétrie peut être également d'un type tel que ledit premier bloc de grille a une dimension critique donnée, ledit deuxième bloc de grille ayant une dimension critique différente de ladite dimension critique donnée.

La dissymétrie peut être également d'un type tel que le premier bloc de grille est séparé de la zone active semi-conductrice par un premier bloc de matériau diélectrique d'épaisseur donnée, le deuxième bloc de grille étant séparé de la zone active semi-conductrice par un deuxième bloc de matériau diélectrique d'épaisseur supérieure à l'épaisseur donnée.

La dissymétrie peut être également d'un type tel que le premier bloc de grille est séparé de la zone active semi-conductrice par un premier bloc de matériau diélectrique d'épaisseur donnée, le deuxième bloc de grille étant séparé de la zone active semi-conductrice par un deuxième bloc de matériau diélectrique d'épaisseur supérieure à l'épaisseur donnée.

La dissymétrie peut être également d'un type tel que lesdites double-grille asymétriques sont formées respectivement d'un premier bloc de grille de composition donnée et d'un deuxième bloc de grille de composition différente de la composition donnée. Par composition différente on entend formée de matériaux différents ou/et d'empilements différents de matériaux ou/et dopés différemment.

Lesdites double-grilles asymétriques peuvent éventuellement être formées avec plusieurs des types de dissymétries cités précédemment.

Ledit deuxième bloc peut appartenir à ladite seconde grille desdits transistors, tandis que ledit premier bloc appartient à ladite première grille desdits transistors.

Pour chacun des premier et deuxième transistor d'accès, la grille qui est reliée aux noeuds de stockage peut être celle des deux grilles qui a la plus faible dimension critique.

L'invention concerne également une mémoire, comprenant une pluralité de cellules telles que définies précédemment.

L'invention concerne également un dispositif microélectronique de mémoire, comprenant une mémoire SRAM telle que définie précédemment.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1, illustre un exemple de cellule mémoire vive statique suivant l'art antérieur,
- les figures 2A et 2B, illustrent respectivement, un exemple de transistor à double-grille de type « planaire », et un autre exemple de transistor à double-grille de type « FinFET »,
- la figure 3, donne l'évolution du courant de canal d'un exemple de transistor double-grille, en fonction de la polarisation de ses deux grilles,
- la figure 4, donne l'évolution du courant de canal d'un exemple de transistor double-grille asymétrique, en fonction de la polarisation de ses deux grilles,
- les figures 5A-5C, illustrent différents modes de réalisation d'une double-grille planaire asymétrique, d'un transistor susceptible d'être intégré dans une cellule mémoire suivant l'invention,
- les figures 6A-6C, illustrent un exemple de procédé de réalisation d'une double-grille planaire asymétrique,
- les figures 7A-7B, illustrent un exemple de procédé de réalisation d'une structure de double-grille asymétrique, et d'une structure de double-grille symétrique sur un même substrat,
- la figure 8, illustre une double-grille asymétrique, d'un transistor de type finFET susceptible d'être intégré dans une cellule mémoire suivant l'invention,
- les figures 9A-9C, illustrent un exemple de procédé de réalisation d'une double-grille asymétrique pour un transistor de type finFET,
- la figure 10 illustre un exemple de cellule mémoire 4T suivant l'invention, dotée de 4 transistors double-grille, dont deux transistors d'accès à double-grille asymétrique,
- la figure 11 représente une portion d'une matrice mémoire dotée de cellules 4T du type de celle de la figure 9,
- la figure 12 illustre un autre exemple de cellule mémoire 4T suivant l'invention, réalisée dans une technologie complémentaire de celle de la cellule de la figure 9,
- la figure 13 illustre un exemple de cellule mémoire 6T suivant l'invention, dotée de 6 transistors double-grille dont 4 transistors d'accès à double-grille asymétrique, de deux lignes de mots, et de 4 lignes de bit,
- les figures 14A, 14B, 14C, illustrent des variantes de réalisation de la cellule mémoire 6T de la figure 12,
- la figure 15 illustre un exemple de cellule mémoire 8T suivant l'invention, dotée de 8 transistors, dont 4 transistors d'accès à double-grille asymétrique, ainsi que de deux lignes de mots, et de 4 lignes de bit,
- les figures 16A, 16B, 16C illustrent des variantes de réalisation de la cellule mémoire 8T de la figure 14.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de dispositif microélectronique suivant l'invention, comprenant au moins une structure de cellule mémoire à accès aléatoire, va à présent être décrit.

La cellule peut être de type SRAM (SRAM pour Static Random Access Memory ou « mémoire statique à accès aléatoire ») et est dotée de transistors double grille, qui peuvent par exemple être réalisés en technologie CMOS (CMOS pour « Complementary Metal Oxide Semi-conductor » ou « semi-conducteur à oxyde de métal complémentaire »). Par transistors double-grille, on entend que ces transistors comportent une première grille et une deuxième grille indépendantes formées de part et d'autre d'une zone active, la première grille et la deuxième grille étant connectées ou non entre elles.

Les transistors de la cellule peuvent avoir une double-grille de structure dite « planaire », formée d'une première grille et d'une deuxième grille, agencées de sorte que la première grille, une zone active semi-conductrice destinée à former un ou plusieurs canaux, et la deuxième grille, sont superposées sur un support.

Sur la figure 2A, un exemple de transistor 10 formé sur un substrat 20 et doté d'une double-grille planaire est donné. La double-grille comprend au moins un premier bloc 30 à base d'au moins un matériau de grille et situé au-dessous d'une zone active 32, et au moins un deuxième bloc 34, à base d'au moins un matériau de grille et situé au-dessus de ladite zone active 32, le premier bloc 30, la zone active 32, le deuxième bloc 34 étant superposés sur le substrat 20 ou situés dans des plans distincts et respectivement parallèles au plan principal du substrat 20 (le plan principal du substrat étant défini sur cette figure comme un plan passant par le substrat et parallèle au plan [O; *̅i̅*̅ ; *̅k̅*̅ ] d' un repère orthogonal [O; *̅i̅*̅; *̅j̅*̅ ;*̅k̅*̅])*.*

Selon une variante, les transistors de la cellule mémoire peuvent être des transistors double-grille et de type dit finFET. Dans ce type de transistor, la double-grille est formée d'une première grille et d'une deuxième grille, agencées de sorte que la première grille, une zone active semi-conductrice destinée à former un ou plusieurs canaux, et la deuxième grille, sont juxtaposées sur un support.

Sur la figure 2B, un exemple de transistor 12 de type « finFET » formé sur un substrat 20 et doté d'une double-grille est donné. La double-grille comprend au moins un premier bloc 40 à base d'au moins un matériau de grille et au moins un deuxième bloc 44 à base d'au moins un matériau de grille, disposés de part et d' autre d' une zone active 42, la zone active et les blocs 40, 44 de la double-grille reposant sur le substrat 20 et étant situés dans un même plan parallèle au plan principal du substrat 20.

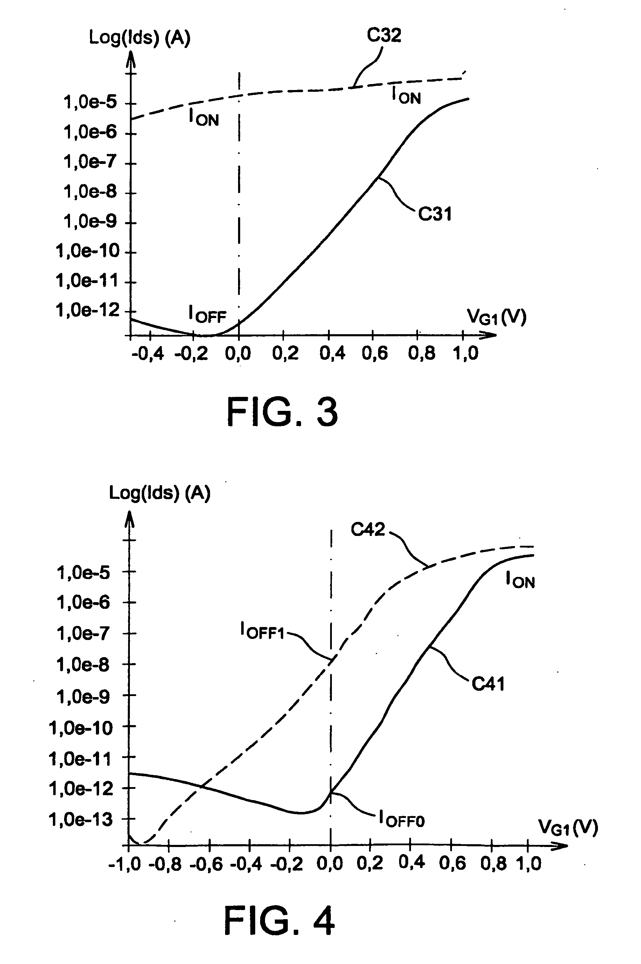

Des caractéristiques électriques d'un transistor double-grille symétrique, sont illustrées sur la figure 3, sur laquelle deux courbes de polarisation C31 et C32 sont données. Sur cette figure, une première courbe de polarisation C31 est représentative de l'évolution du courant drain-source Ids en fonction d'un potentiel Vg1 appliqué sur une première grille du transistor, lorsque la deuxième grille du transistor se trouve dans un premier état de polarisation et qu'un potentiel Vg2 déterminé, par exemple de 0 Volt est appliqué sur la deuxième grille. Une deuxième courbe de polarisation C32 est représentative de l'évolution du courant drain-source Ids en fonction d'un potentiel Vg1, appliqué sur la première grille du transistor, lorsque la deuxième grille du transistor se trouve dans un troisième état de polarisation et qu'un autre potentiel Vg2 déterminé, par exemple de 1 Volt, est appliqué sur la deuxième grille.

La cellule mémoire à accès aléatoire suivant l'invention est dotée de transistors à double-grille asymétrique. La cellule mémoire peut en particulier être dotée de transistors d'accès dont la double-grille est asymétrique.

Une double-grille asymétrique est formée de deux grilles distinctes dissymétriques par rapport au plan principal de la zone active semi-conductrice de part et d'autre de laquelle ces grilles sont disposées. Dans un transistor doté d'une double-grille asymétrique, le courant délivré entre le drain et la source du transistor est différent suivant que la première grille ou la deuxième grille est activée, même pour une polarisation identique.

La figure 4 donne des caractéristiques électriques d'un exemple de transistor double-grille asymétrique susceptible d'être intégré dans une cellule mémoire suivant l'invention. Sur cette figure, des courbes C₄₁, C₄₂ sont représentatives, de l'évolution du courant traversant la zone active du transistor, entre son drain et sa source, en fonction d'un potentiel V_{G1} appliqué sur sa première grille pour différents valeurs fixes d'un potentiel V_{G2} appliqué sur sa deuxième grille. La courbe C₄₁ est donnée pour une première valeur de potentiel V_{G2} qui, dans cet exemple, est de 0 volt, tandis que la courbe C₄₂ est donnée pour une deuxième valeur de potentiel V_{G2} qui, dans cet exemple, est de 1 volt. Cet exemple de transistor se caractérise par deux courants I_{ON} à l'état passant pour un potentiel appliqué sur la première grille V_{G1}=VDD et un potentiel appliqué sur la deuxième grille V_{G1} tel que V_{G1}=V_{G2}=VDD et deux courants I_{OFF} à l' état bloqué pour V_{G1}= 0V suivant que V_{G2}=0V ou VDD.

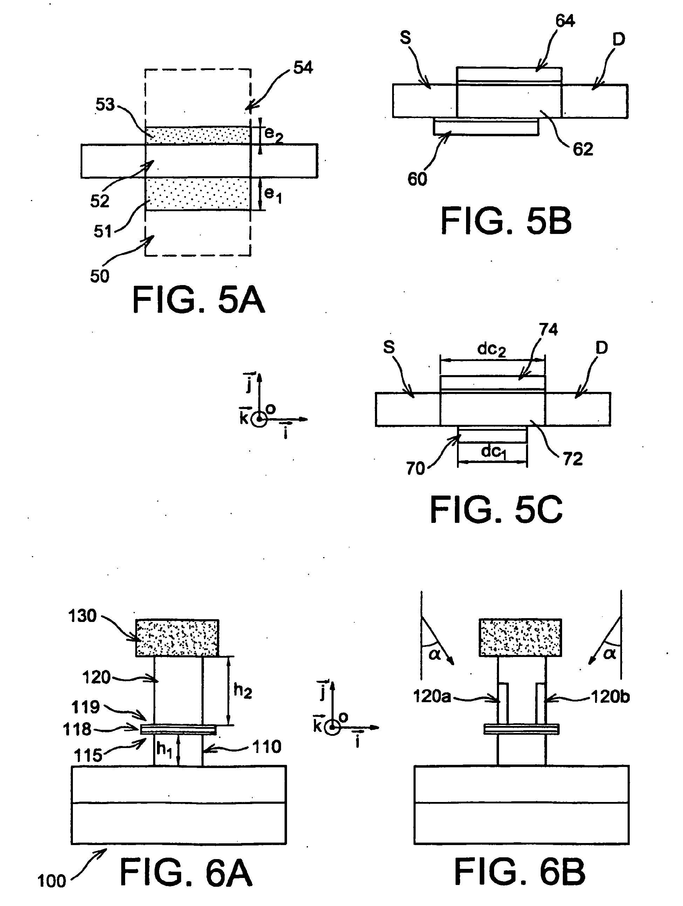

Les figures 5A à 5C donnent différents exemples de dissymétries qu'une structure double-grille planaire asymétrique d'un transistor intégré à une cellule mémoire suivant l'invention, est susceptible de comporter.

L'asymétrie de la double-grille peut être obtenue notamment en formant deux couches de diélectriques de grilles d'épaisseur différentes.

La figure 5A, illustre un exemple de structure de transistor à double-grille planaire asymétrique dotée d'une première grille 50 ou grille inférieure, en contact avec une première couche 51 de diélectrique de grille d'épaisseur e₁, et d'une deuxième grille 54 formée sur une deuxième couche de diélectrique de grille d'épaisseur e₂ inférieure à e₁. Les deux grilles 50 et 54 sont ainsi placées à des distances respectives différentes de la zone active 52 semi-conductrice située entre le drain et la source du transistor.

Un autre exemple de dissymétrie est illustré sur la figure 5B. Sur cette figure, un transistor à double-grille planaire asymétrique est doté d'une première grille 60 formée au-dessous et en regard d'une zone active semi-conductrice 52 situé entre la région de source S et la région de drain D du transistor, et d'une deuxième grille 64 formée au-dessus et en regard d'une partie de ladite zone active semi-conductrice 52 et d'une partie de la région de source S. Les deux grilles 60, 64 ne sont pas symétriques par rapport à une normale au plan principal de la zone active 52 (le plan principal de la zone active étant défini sur cette figure comme un plan passant par la zone active et parallèle au plan [O; *̅i̅*̅ ; *̅k̅*̅ ] d'un repère orthogonal [O; *̅i̅*̅ ; *̅j̅*̅ ; *̅k̅*̅])*.*

L'asymétrie peut être également obtenue notamment en formant deux grilles de dimension critiques différentes.

La figure 5C, illustre un exemple de structure de transistor à double-grille planaire asymétrique doté d'une première grille 72 ou grille inférieure, de dimension critique dc₁ et d'une deuxième grille 74 ou grille supérieure, de dimension critique dc₂ supérieure à dc₁.

Une double grille combinant plusieurs types des dissymétries précités peut être également mise en oeuvre, par exemple ayant deux grilles de dimensions critiques différentes.

Un exemple détaillé de procédé de réalisation d'une structure de double-grille planaire asymétrique, formée de deux grilles de cotes ou dimensions critiques différentes, va à présent être donné en liaison avec les figures 6A à 6C.

On réalise tout d'abord sur un support 100, une structure formée d'un empilement tel qu'illustré sur la figure 6A, comprenant un premier bloc 110 de grille, un première zone 115 de diélectrique de grille reposant sur le premier bloc 110, une zone semi-conductrice 118 reposant sur la première zone diélectrique 115, une deuxième zone 119 de diélectrique de grille reposant sur la zone semi-conductrice 118, un deuxième bloc 120 de grille reposant sur la deuxième zone 119 diélectrique. Le deuxième bloc 120 de grille peut être réalisé avec une hauteur h₂ supérieure à la hauteur h₁ du premier bloc de grille (les hauteurs h₁ et h₂ étant des dimensions définies dans une direction parallèle au vecteur j d'un repère orthogonal [O; *̅i̅*̅ ; *̅j̅*̅; *̅k̅*̅] sur la figure 6A). Le deuxième bloc 120 de grille peut être également surmonté d'un masque dur 130 à base de matériau diélectrique. Les zones diélectriques 115 et 119 et la zone semi-conductrice 120 ont une côte ou dimension critique supérieure à celle du premier bloc 110 de grille et du deuxième bloc 120 de grille (les dimensions critiques étant des dimensions définies dans une direction parallèle au vecteur *̅i̅*̅ du repère orthogonal [O; *̅i̅*̅ ; *̅j̅*̅ ; *̅k̅*̅] sur la figure 6A). Le masque dur 130 peut également avoir une côte ou dimension critique supérieure à celle du premier bloc 110 et du deuxième bloc 120. Le deuxième bloc 120 de grille peut être formé par exemple d'une couche à base de polysilicium. Le premier bloc 110 de grille peut être également formé par exemple d'une couche à base de polysilicium. Pour réaliser le premier bloc 110 et le deuxième bloc 120 on peut avoir effectué une gravure, par exemple anisotrope, d'un empilement de couches minces à travers un masque dur, de manière à former le premier bloc de grille, la première zone diélectrique, la zone semi-conductrice, la deuxième zone diélectrique, le deuxième bloc de grille. On peut ensuite avoir effectué une deuxième gravure isotrope, sélective vis-à-vis de la zone semi-conductrice 118 et des zones diélectriques 115 et 119, de manière à réduire latéralement le premier bloc et le deuxième bloc de grille.

Après avoir obtenu cette structure, on réalise une implantation ionique inclinée (figure 6B) selon un angle α prédéterminé par rapport à une normale au plan principal du support 100 (le plan principal du support étant défini sur la figure 6B comme un plan passant par le support et parallèle au plan [O; *̅i̅*̅ ; *̅k̅*̅]).

Les dimensions critiques des zones diélectriques 115, 199, les hauteurs h₁ et h₂ respectives du premier bloc 110 de grille et du deuxième bloc de grille 120, ainsi que l'angle α d'implantation sont prévus de manière à réaliser un dopage du deuxième bloc de grille, de préférence sans doper ou en dopant moins le premier bloc 110. On réalise de préférence un dopage de zones 120a, 120b situées au niveau des flancs du deuxième bloc sans doper le premier bloc 110 ou en dopant moins le premier bloc 110 ou de préférence sans doper le premier bloc 110 dans la zone de ce dernier située en contact avec la zone 115 de diélectrique de grille.

Les zones implantées 120a, 120b, du deuxième bloc 120 sont de préférence en contact avec la deuxième zone diélectrique 119. L'implantation peut être effectuée à une dose et une énergie choisies en fonction de la différence de dimensions critiques finales souhaitée entre le premier bloc et le deuxième bloc. L'implantation peut être par exemple une implantation d'Arsenic à une dose de 3e15 atomes.cm-2 et une énergie dimensionnée en fonction de la différence de dimension critique souhaitée. Selon une variante l'implantation, peut être réalisée avec du Germanium.

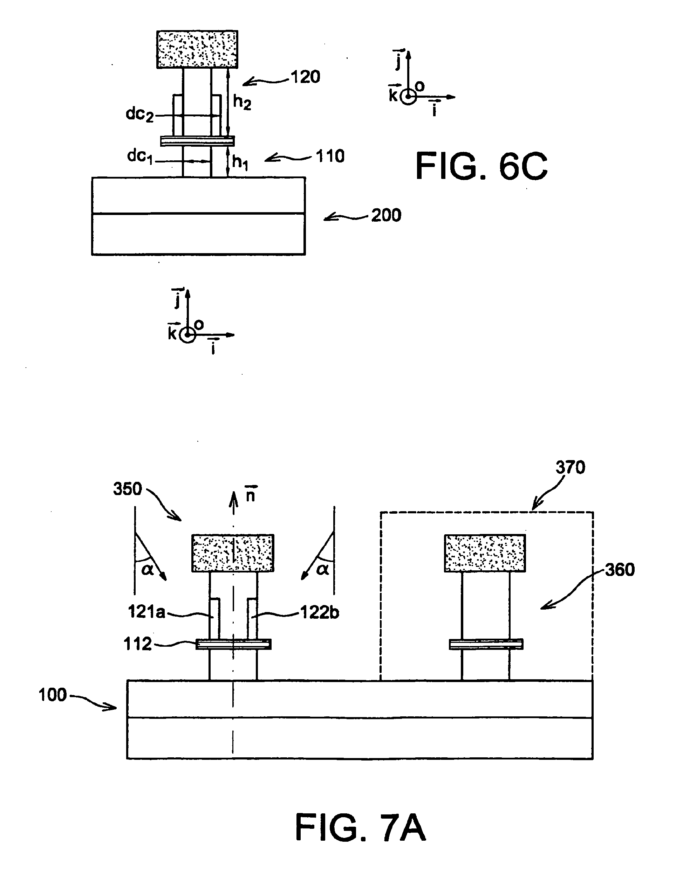

Ensuite, on réalise une gravure sélective vis-à-vis des parties implantées du deuxième bloc. Après cette gravure, le deuxième bloc 120 a une dimension critique dc₂ supérieure à la dimension critique dc₁ du premier bloc 110 (figure 6C). Dans le cas où le premier bloc 110 et le deuxième bloc 120 sont à base de polysilicium, la gravure pourrait être une gravure chimique par voie humide mise en oeuvre afin d'obtenir une sélectivité de gravure du polysilicium dopé par rapport au polysilicium, par exemple à l'aide de TMAH (Tetra-Methyl-Ammonium Hydroxide). Dans le cas où le premier bloc et le deuxième bloc sont à base de polysilicium, l'implantation réalisée précédemment peut être une implantation de germanium dans le polysilicium, de manière à utiliser ensuite un procédé de gravure sélective par exemple à base de CF₄ du polysilicium implanté avec du Germanium, par rapport au polysilicium.

Selon une variante du procédé qui vient d'être décrit, les blocs 110 et 120 peuvent être formés d'un empilement d'une couche semi-conductrice, par exemple à base de polysilicium et d'une couche métallique, par exemple à base de TiN.

Le procédé précédemment décrit peut être mis en oeuvre pour réaliser ou co-intégrer sur un même support ou un même substrat 100, des transistors à double-grille planaire asymétriques et des transistors planaires symétriques.

Pour cela, on réalise sur un substrat tel que le substrat 100, plusieurs structures, par exemple une première structure 350, et une deuxième structure 360 du type de la structure 150 précédemment décrite. Ensuite, préalablement à l'étape d'implantation sélective, on forme des moyens de protection vis-à-vis d'un faisceau ionique d'implantation pour au moins une structure particulière parmi les structures 350, 360 réalisées sur le substrat 100, par exemple pour la deuxième structure 360. Ces moyens de protection peuvent être formés d'au moins une couche 370 définie par exemple par photolithographie et recouvrant la deuxième structure 360. La couche 370 de protection dévoile au moins une autre structure 350 et peut être par exemple une couche à base de résine ou un masque dur, par exemple à base de Si₃N₄ ou de SiO₂ (figure 7A).

Ensuite, on réalise une implantation sélective du deuxième bloc de grille de la première structure 350, par exemple de la manière décrite précédemment en liaison avec la figure 6B. Lors de cette implantation, la couche 370 protège la deuxième structure 360 du faisceau de particules. Ensuite, on retire la couche de protection 370.

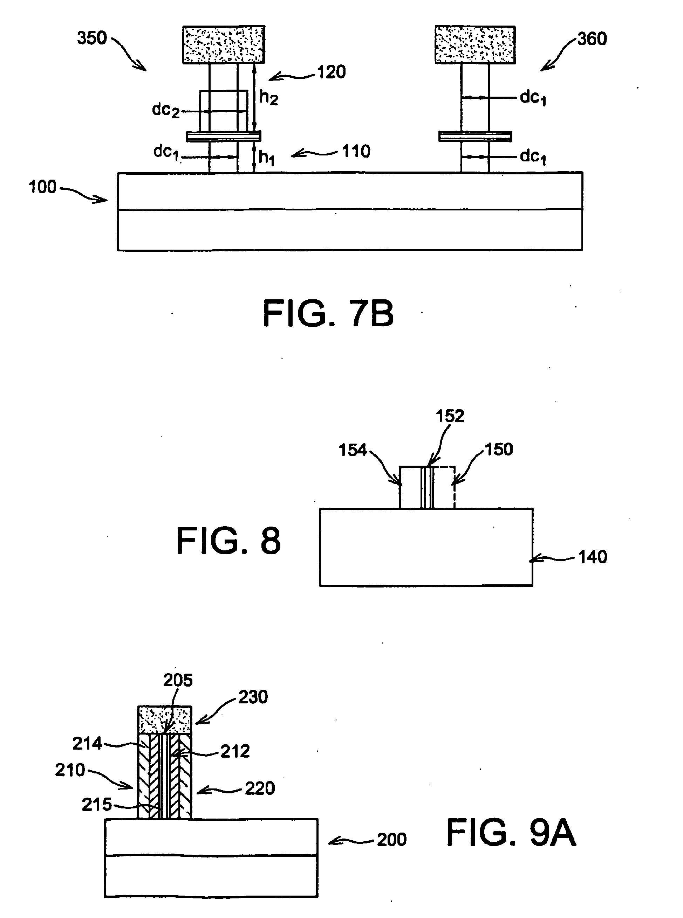

Puis, on réalise l'étape de gravure des blocs de grilles de la première structure 350 et de la deuxième structure 360. Cette gravure est une gravure sélective des zones semi-conductrices implantées vis-à-vis de zones semi-conductrices qui n'ont pas été implantées. Sur la figure 7B, la première structure 350 et la deuxième structure 360 reposant sur le substrat 100 sont représentées, une fois la gravure réalisée. La première structure 350 comporte un premier bloc 110a de grille de dimension critique dc₁, et un deuxième bloc 120a destiné à former une deuxième grille de dimension critique dc₂, les zones semi-conductrices 121a, 122a implantées ayant été moins gravées que les zones semi-conductrices non implantées. La deuxième structure 360 une fois la gravure sélective réalisée, comporte un premier bloc 310a destiné à former une première grille, a une dimension critique dc₁, tandis que le deuxième bloc 320b destiné à former une deuxième grille a une dimension critique dc₁, identique à celle du premier bloc. La première structure 350 est prévue pour un transistor à double-grille asymétrique tandis que la deuxième structure 360, réalisée sur le même substrat 100 que la première, est prévue pour un transistor double-grille symétrique.

Sur la figure 8, un exemple de structure de double-grille asymétrique d'un transistor de type finFET, susceptible d'être intégré dans une cellule mémoire suivant l'invention est donné. Dans cet exemple, une première grille 150 et une deuxième grille 154 reposent sur un substrat 140 de part et d'autre d'une zone active 152 semi-conductrice, et sont disposées contre les flancs de cette zone 152. La dissymétrie de la double-grille peut être une dissymétrie géométrique par rapport à la zone active ou/et une dissymétrie de composition entre les deux grilles 152 et 154. Par dissymétrie de composition, on entend que les deux grilles sont à base de matériaux différents, ou/et sont formées d'empilements différents de matériaux ou/et sont dopées différemment.

Un exemple de réalisation, d'une double-grille asymétrique pour un transistor finFET, formée de deux grilles dopées différemment l'une de l'autre, est donnée en liaison avec les figures 9A-9C.

Dans cet exemple, on réalise tout d'abord, une structure de double-grille, comportant deux grilles 210, 220, de part et d'autre d'une zone semi-conductrice 205. La première grille 210 et la deuxième grille 220 sont formées chacune d'un bi-couche comportant une couche inférieure 212 métallique, en contact avec une couche de diélectrique 215 de grille, et une deuxième couche supérieure 214 semi-conductrice, en contact avec la première couche métallique 212. La couche de diélectrique de grille peut être par exemple à base de SiO₂ ou de HfO₂ et d'épaisseur comprise par exemple entre 1 et 5 nanomètres. La couche métallique 212 peut être par exemple à base de TiN et d'épaisseur comprise par exemple entre 1 et 5 nanomètres. La couche semi-conductrice 214 peut être par exemple à base de polysilicium et d'épaisseur comprise par exemple entre 1 et 50 nanomètres (figure 9A).

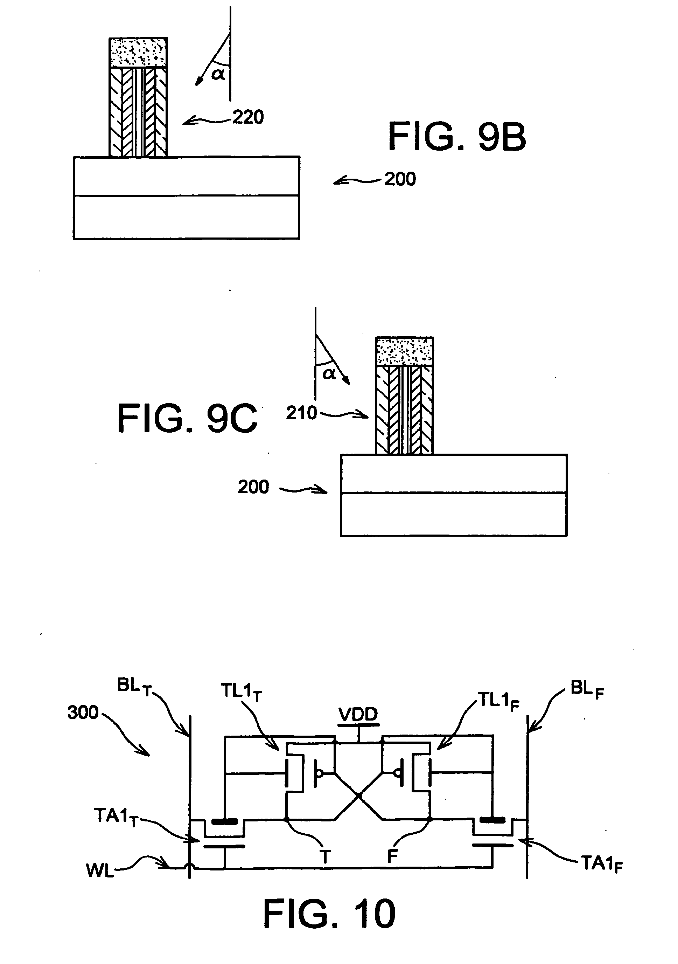

Une fois cette structure formée, on réalise une première implantation inclinée sur la première grille 210 situé d'un côté de la zone semi-conductrice 205, de manière à réaliser un dopage d'un premier type, par exemple de type N, de la couche supérieure 214 semi-conductrice de la première grille 210 (figure 9B).

Puis, on réalise une autre implantation inclinée sur la deuxième grille 220 située de l'autre côté de la zone semi-conductrice 205, de manière à réaliser un dopage d'un deuxième type, par exemple de type P, de la couche supérieure 214 semi-conductrice de la deuxième grille 220 (figure 9C).

La dissymétrie peut être également obtenue par différentes épaisseurs de la couche métallique 212 de part et d'autre de la zone semi-conductrice. En fonction de l'épaisseur de la couche inférieure 212, le travail de sortie de chaque grille varie entre un travail de sortie proche de celui de la couche supérieure, lorsque la couche inférieure est très fine, et celui de la couche inférieure, lorsque cette dernière dépasse plusieurs dizaines de nanomètres. Le travail de sortie de la grille formée du bi-couche par exemple TiN/polysilicium dopé N varie avec l'épaisseur de la couche métallique TiN. Quand la couche de TiN est très mince, par exemple de 5 nm, la tension de seuil Vth du NMOS peut être par exemple de l'ordre de 0,2 V ce qui équivaut à un travail de sortie du bicouche de l'ordre 4,7 eV alors que lorsque l'épaisseur de TiN est à 10 nm, la tension de seuil passe à 0,4 V soit un travail de sortie d'environ 4,5 eV. Le polysilicium dopé N a un travail de sortie d'environ 5,1 eV. Lorsque la couche inférieure est très mince, on peut déplacer le travail de sortie du bicouche vers celui de la couche supérieure même lorsque cette dernière est en polysilicium.

Un premier exemple de cellule mémoire 300 à accès aléatoire suivant l'invention, est illustré sur la figure 10.

Cette cellule mémoire 300 est une cellule de mémoire statique SRAM de type 4T, dotée de 4 transistors à double-grille, par exemple réalisés en technologie MOS. La cellule 300 comprend une première pluralité de transistors formant un premier inverseur et un deuxième inverseur, connectés selon une configuration de bascule ou communément appelée « flip-flop ». La première pluralité de transistors peut être formée d'un premier transistor de charge TL1_{T}, ainsi que d'un deuxième transistor de charge TL1_{F}. Les transistors de charge TL1_{T} et TL1_{F}, peuvent être réalisés dans un premier type de technologie MOS donnée, par exemple une technologie de type PMOS. Les deux grilles du premier transistor de charge TL1_{T} sont connectées l'une à l'autre, tandis que les deux grilles du deuxième transistor de charge TL1_{F} sont également connectées ensemble. La double-grille du deuxième transistor de charge TL1_{F} est également connectée à un premier noeud de stockage T de la première cellule 300, tandis que la double-grille du premier transistor de charge TL1_{T} est également connectée à un deuxième noeud de stockage F de la première cellule 300. Les sources des transistors de charge TL1_{T}, TL1_{F}, peuvent quant à elles, être reliées entre elles et à un potentiel d'alimentation VDD, tandis que le drain du premier transistor de charge TL1_{T} peut être relié au premier noeud T et que le drain du deuxième transistor de charge TL1_{F} est relié au deuxième noeud F. Les transistors de charge TL1_{T} et TL1_{F} sont prévus pour maintenir une charge nécessaire à l'établissement d'un niveau logique donné par exemple un niveau '1', correspondant par exemple à un potentiel égal au potentiel d'alimentation VDD, sur l'un ou l'autre des noeuds T ou F, en fonction de la valeur logique mémorisée dans la cellule 300. Les transistors de charge TL1_{T} et TL1_{F} peuvent être dotés d'une double-grille symétrique.

La première cellule 300 est également dotée d'un premier transistor d'accès TAL_{T} à double-grille asymétrique et d'un deuxième transistor d'accès TA1_{F} à double-grille asymétrique. Les transistors d'accès TA1_{T}, TA1_{F} peuvent être par exemple de type NMOS. Le premier transistor d'accès TA1_{T} et le deuxième transistor d'accès TA1_{F} comportent chacun une première grille reliée à une première ligne de mot WL. La seconde grille du premier transistor d'accès TA1_{T} est reliée au premier noeud de stockage T, tandis que la seconde grille du deuxième transistor d'accès TA1_{F} est reliée au deuxième noeud de stockage F. La source du premier transistor d'accès TAL_{T} est reliée à une première ligne de bit BL_{T}, tandis que la source du deuxième transistor d'accès TA1_{F} est reliée à une deuxième ligne de bit BL_{F}. Le drain du premier transistor d'accès TAL_{T} est quant à lui relié au premier noeud de stockage T, tandis que le drain du deuxième transistor d'accès TA1_{F} est relié au deuxième noeud de stockage F. Les transistors d'accès TA1_{T}, TA1_{F}, sont agencés de manière à permettre d'accéder aux noeuds de stockage T et F, lors d'une phase de lecture ou d'écriture de la cellule 300, et à bloquer l'accès à la cellule 300, lorsque la cellule 300 est dans un mode de rétention d'information.

Une telle cellule 300 permet d'obtenir une marge au bruit statique ainsi qu'un compromis entre la stabilité en rétention et la stabilité en lecture améliorés. Dans cet exemple, un maintien de l'information stockée en rétention sans faire appel à des moyens de rafraîchissement est également réalisé. La ligne de mot WL, est commandée en fonction du mode dans lequel on souhaite placer la cellule 300.

Un exemple de fonctionnement d'une telle cellule 300 est le suivant :
En mode de rétention, les lignes de bit BL_{T}, BL_{F} sont reliées à un potentiel VSS tandis que la ligne de mot WL est également maintenue au potentiel VSS afin de stabiliser une donnée mémorisée. Les transistors d'accès TA1_{T} et TA1_{F} sont quant à eux dans un état bloqué. Dans le cas où le premier noeud T est à un niveau logique haut et le deuxième noeud F à un niveau bas, le deuxième transistor de charge TL1_{F} est également bloqué, seul le premier transistor de charge TL1_{T} étant conducteur. Pour garder le potentiel du deuxième noeud F proche de VSS, le courant qui traverse le deuxième transistor d'accès TA1_{F} doit être supérieur à la somme du courant qui traverse le deuxième transistor de charge TL1_{F} et du courant de grille issu de premier transistor de charge TL1_{T}. La connexion de la seconde grille du deuxième transistor d'accès TA1_{F} au premier noeud de stockage T, mis à VDD, permet d'augmenter son courant de fuite par exemple de 2 à 3 décades et ainsi de garantir une bonne stabilité en rétention. La mise en oeuvre de transistors d'architecture double-grille asymétrique permet de réaliser cette condition dans la mesure où, compte tenu des conditions de polarisation, le deuxième transistor d'accès TA1_{F} présente une tension de seuil inférieure à celle du deuxième transistor de charge TL1_{F}.
En mode lecture, les lignes de bit sont initialement chargées ou préchargées à un potentiel VSS. Ensuite, la ligne de mot est polarisée à un potentiel VDD prévu de manière à permettre un accès aux noeuds de stockage T, F. La stabilité de la cellule 300 en mode lecture dépend de la relation entre les courants de conduction des transistors TL1_{T} et TAL_{T}. Pour obtenir une marge au bruit maximale, le courant de conduction, qui traverse le premier transistor d'accès TA1_{T} est prévu inférieur au courant de conduction du premier transistor de charge TL1_{T}. La connexion de la seconde grille du premier transistor d'accès TAL_{T} au noeud de stockage F, de tension nulle, permet de limiter le courant à l'état passant du premier transistor d'accès TAL_{T} et ainsi de garantir une bonne stabilité de la cellule 300 en lecture. La mise en oeuvre de transistors d'architecture double-grille permet de réaliser cette condition, puisque compte tenu des conditions de polarisation en mode lecture, le premier transistor d'accès TAL_{T} sera doté d'un canal, tandis que le premier transistor de charge TL1_{T} sera doté de deux canaux.
En mode écriture, pour écrire par exemple une valeur logique '0' sur le premier noeud T de sorte que T=0, et F=1, la deuxième ligne de bit BL_{F} est initialement chargée ou préchargée à un potentiel VDD tandis que la première ligne de bit BLT est maintenue à un potentiel VSS. Ensuite, la ligne de mot WL est polarisée au potentiel VDD pour activer les transistors d'accès TA1_{T} et TA1_{F} afin de connecter les noeuds de stockage aux lignes de bit.

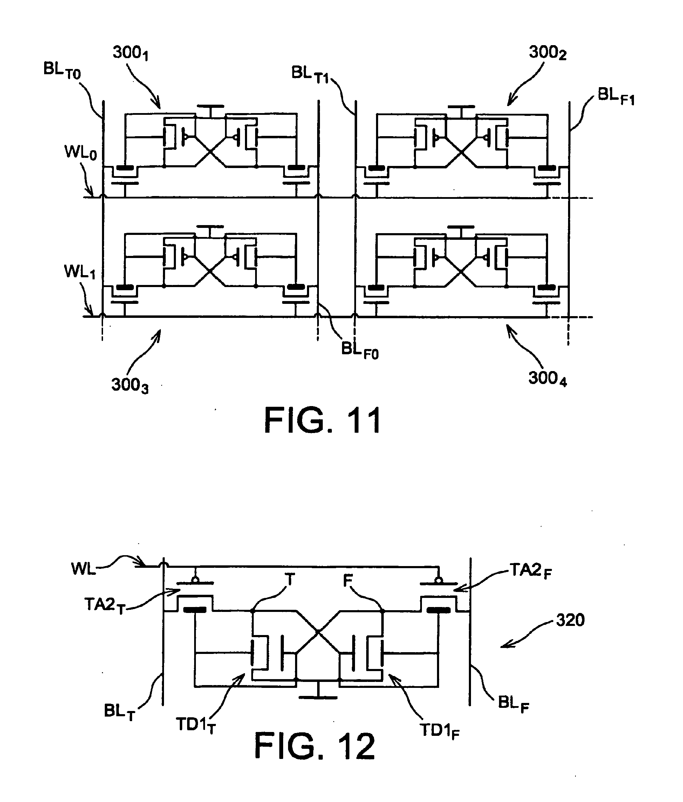

La cellule mémoire 300 qui vient d'être décrite peut être intégrée dans une matrice mémoire, comme cela est illustré sur la figure 11. Sur cette figure, 4 cellules 300₁, 300₂, 300₃, 300₄, parmi N cellules (avec N>0) du type de la cellule 300, d'une matrice mémoire sont représentées. La matrice mémoire est formée de p colonnes, chaque colonne comprenant m cellules du type de la cellule 300. Dans cet exemple, chacune des colonnes de la matrice comporte deux lignes de bit BLT₀, BLF₀, BLT₁, BLF₁,..., et est contrôlée par un décodeur de colonne. Les m*p cellules mémoires sont commandées par m lignes de mot WL₀, WL₁....

Sur la figure 12, un deuxième exemple de cellule 320 à quatre transistors, complémentaire de la première cellule 300 décrite précédemment est donné. Dans cet exemple, les transistors de charge sont remplacés par des transistors de conduction TD1_{T}, TD1_{F} à double-grille, et par exemple de type NMOS. Les transistors de conduction TD1_{T}, TD1_{F} sont connectés à un potentiel VSS. La cellule 320 est également dotée de transistors d' accès TA_{2T}, TA_{2F} réalisés dans une technologie complémentaire de celle des transistors d'accès de la première cellule 300, par exemple en technologie PMOS.

Selon une variante de mise en oeuvre, dans un cas où l'on souhaite privilégier une stabilité de la cellule en mode lecture, un dispositif de rafraîchissement des données mémorisées peut être associé à la cellule. Dans ce cas, le comportement de la cellule est dynamique.

Pour améliorer la stabilité de la cellule en mode lecture, sans détériorer la stabilité en rétention, on peut réduire le potentiel de la ligne de mot WL activée en lecture, à une valeur comprise entre Vss et Vdd.

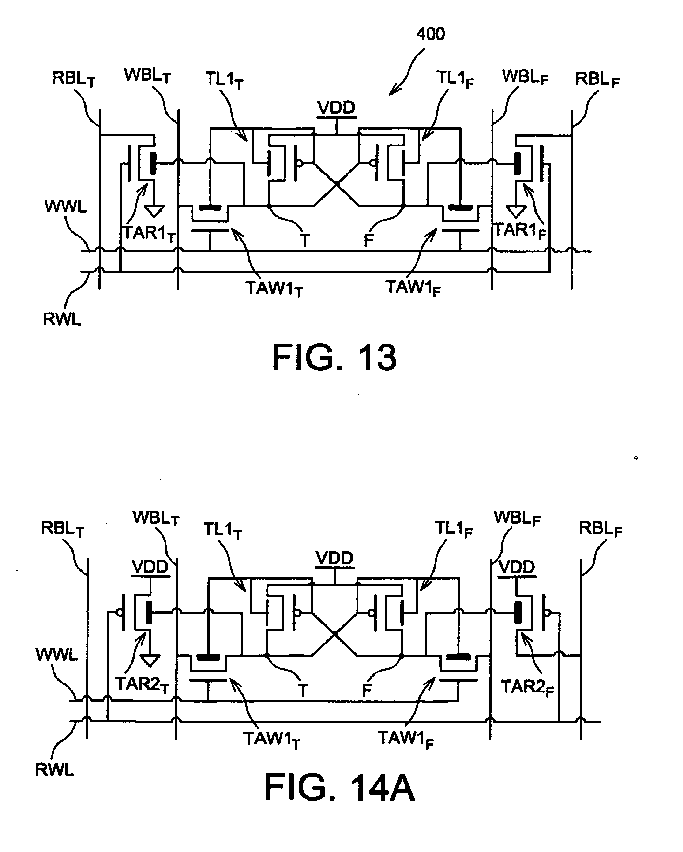

La figure 13 illustre un exemple de cellule mémoire 400, suivant l'invention, dotée de 6 transistors. Cette cellule mémoire 400 a un coeur semblable à celui du premier exemple de cellule 300 décrit précédemment. Sur cette figure, le premier transistor d'accès et le deuxième transistor d'accès sont cette fois référencés respectivement TAW1_{T} et TAW1_{F}, tandis que la première ligne de bit, la deuxième ligne de bit, sont référencées respectivement WBL_{T} et WBL_{F}. La cellule 400 comporte une ligne de mot WWL connectés à la première grille du premier et deuxième transistor d'accès, et est en outre dotée d'une deuxième ligne de mot RWL, et deux autres lignes de bit RBL_{T} et RBL_{F}. La cellule 400, comporte également un troisième transistor d'accès à double-grille asymétrique TAR1_{T}, et un quatrième transistor d'accès à double-grille asymétrique TAR1_{F}, réalisés, par exemple en technologie NMOS. La première grille du troisième transistor d'accès et la première grille du deuxième transistor d'accès sont reliées à la deuxième ligne de mot RWL. La seconde grille du premier transistor d'accès est reliée au deuxième noeud de stockage F, tandis que la seconde grille du deuxième transistor d'accès est reliée au premier noeud de stockage T.

La deuxième ligne de mot RWL, les troisième et quatrième lignes de bits RBL_{T} et RBL_{F} et le troisième et quatrième transistors d'accès TAR1_{T}, TAR1_{F}, sont dédiés aux opérations de lecture de la cellule 400. La première ligne de mot WWL, les lignes de bits WBLT, WBLF ainsi que le premier transistor d'accès TAW1_{T}, et deuxième transistor d'accès TAW1_{F} sont dédiés aux opérations d'écriture.

Un exemple de fonctionnement de la cellule mémoire 400 à 6 transistors va à présent être donné :
En mode de rétention la deuxième ligne de mot RWL est maintenue à VSS ou à un potentiel inférieur à VSS afin de réduire les courants de fuite. Les troisième et quatrième lignes de bits RBL_{T} et RBL_{F} peuvent quant à elles être préchargées ou chargées initialement à un potentiel VDD ou laissées flottantes.
En mode lecture, les troisième et quatrième lignes de bits RBL_{T} et RBL_{F} sont préchargées ou chargées initialement à VDD ou à un potentiel supérieur à VSS. Ensuite, la deuxième ligne de mot RWL est polarisée à VDD. Le troisième transistor d'accès TAR1_{T}, dont la seconde grille est connectée au premier noeud T, laisse passer un courant de lecture plus important que celui traversant le quatrième transistor TAR1_{F}, déchargeant plus rapidement la troisième ligne de bit RBL_{T}. Dans ce cas, la cellule 400 est particulièrement avantageuse du fait que la tension du premier noeud T n'est pas diminuée par le courant de lecture. Il s'en suit que la stabilité en lecture de la cellule 400 est identique à sa stabilité en rétention. Par conséquent la stabilité globale de la cellule 400 est fortement améliorée sans avoir à faire de compromis entre stabilité en mode rétention et stabilité en mode lecture.
En mode écriture, pour écrire par exemple un état logique '0' sur le premier noeud T, la deuxième ligne de bit WBL_{F} est préchargée à un potentiel VDD tandis que la première ligne de bit WBL_{T} est maintenue à VSS. Ensuite, la première ligne de mot WWL est polarisée à VDD pour activer les transistors d'accès et connecter les noeuds de stockage aux première et deuxième lignes de bit WBL_{T} et WBL_{F}. Pendant le cycle d'écriture, la deuxième ligne de mot RWL est maintenue à VSS. Dans le cas où la cellule mémoire est utilisée dans un mode de basse consommation et qu'il n'y a pas d'accès mémoire, pour limiter les courants de fuite des troisième et quatrième transistors d'accès TAR1_{T} et TAR1_{F}, les troisième et quatrième lignes de bit RBL_{T} et RBL_{F} peuvent être maintenues à la masse afin de développer une différence de potentiel entre le drain et la source des transistors d'accès TAR1_{T} et TAR1_{F} nulle.

Les figures 14A à 14C, illustrent des variantes de réalisation de la cellule 400 à 6 transistors qui vient d'être décrite.

Sur la figure 14A, un deuxième exemple de cellule 420 à 6 transistors est représenté. Cette cellule 420 diffère de la cellule 400 en ce qu'elle comporte un troisième et un quatrième transistors d'accès TAR2_{T} et TAR2_{F} réalisés dans une technologie, par exemple PMOS, complémentaire de celle des transistors d'accès TAR1_{T} et TAR1_{F} de la cellule 400. Un exemple de tableau logique de fonctionnement de la cellule 420 est donné ci-dessous :

| | Rétention | Lecture | Ecriture |
|---|---|---|---|
| WWL | 0 | 0 | 1 |
| RWL | 1 | 0 | 1 |
| WBL | 0 | 0 | 0/1 |
| RBL | 0/1 | 0 | 0/1 |

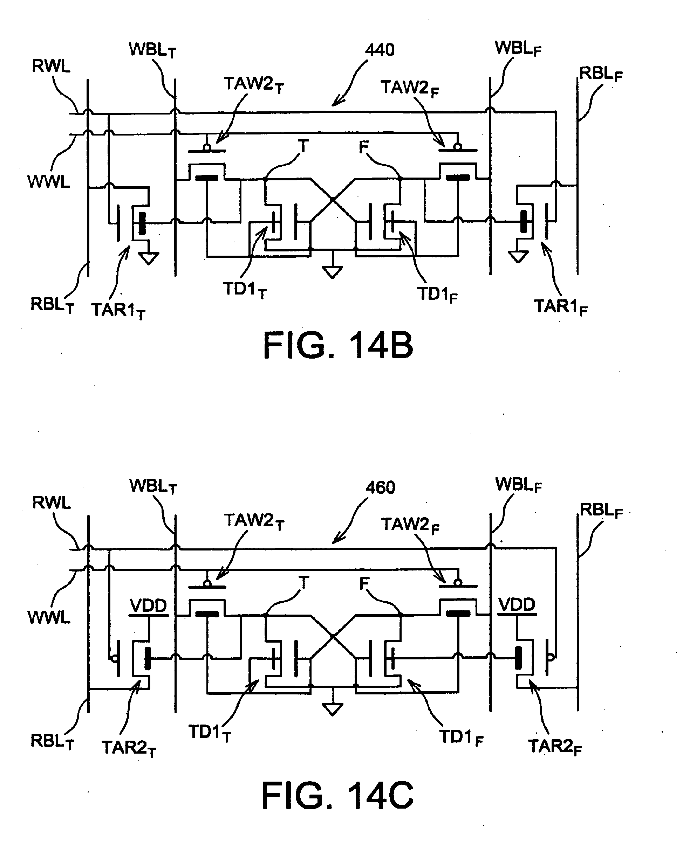

Sur la figure 14B, un troisième exemple de cellule 440 à 6 transistors est représentée. Cette cellule 440 diffère de la cellule 400 en ce que le premier et deuxième transistors d'accès TAW2_{T} et TAW2_{F} sont réalisés dans une technologie, par exemple PMOS, complémentaire de celle des transistors d'accès TAW1_{T} et TAW1_{F} de la cellule 400. La cellule 440 diffère également de la cellule 400 en ce qu'elle comporte deux transistors de conduction TD1_{T} et TD1_{F} à la place des transistors de charge TL1_{T} et TL1_{F}.

Un exemple de tableau logique de fonctionnement de la cellule 440 est donné ci-dessous :

| | Rétention | Lecture | Ecriture |
|---|---|---|---|
| WWL | 1 | 1 | 0 |
| RWL | 0 | 1 | 0 |
| WBL | 1 | 1 | 0/1 |
| RBL | 0/1 | 1 | 0/1 |

Sur la figure 14C, un quatrième exemple de cellule à 6 transistors est donné. Cette cellule référencée 460, diffère de la cellule 440 précédemment décrite en ce qu'elle comporte un troisième et un quatrième transistor d'accès TAR2_{T} et TAR2_{F} réalisés dans une technologie, par exemple PMOS, complémentaire de celle des transistors d'accès TAR1_{T} et TAR1_{F} de la cellule 440.

Un exemple de tableau logique de fonctionnement de la cellule 460 est donné ci-dessous :

| | Rétention | Lecture | Ecriture |
|---|---|---|---|
| WWL | 1 | 1 | 0 |
| RWL | 1 | 0 | 1 |
| WBL | 1 | 1 | 0/1 |
| RBL | 0/1 | 0 | 0/1 |

Une cellule (non représentée) à 6 transistors dotée chacun d'une double-grille asymétrique peut être également mise en oeuvre.

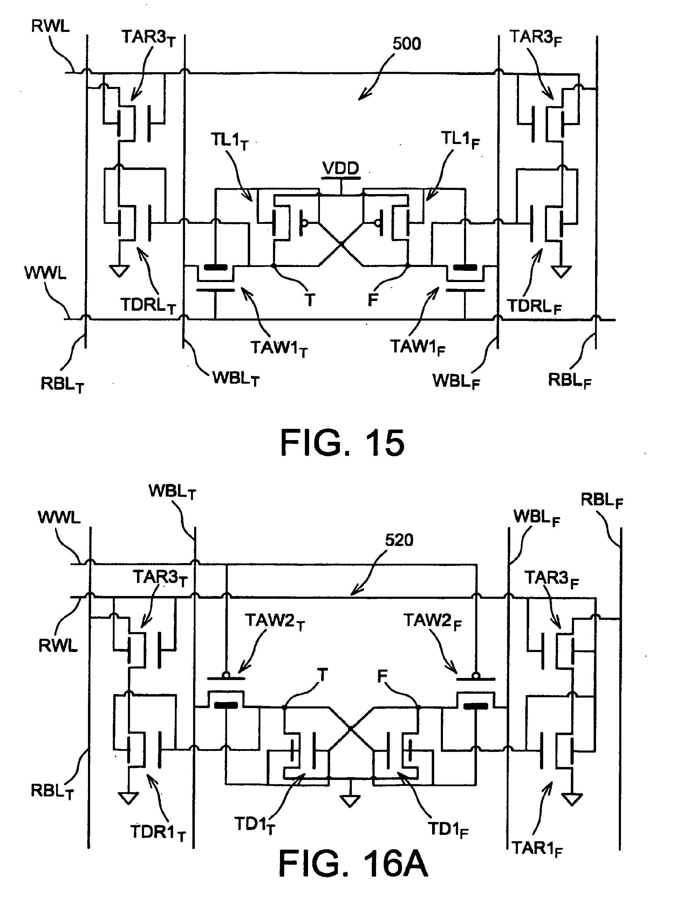

Un autre exemple de cellule mémoire à accès suivant l'invention est donné sur la figure 15. Cette cellule référencée 500, dite « 8T » ou à 8 transistors, peut être dotée d'un coeur semblable à celui des cellules à 4 transistors 300, ou 6 transistors 400 précédemment décrite. Par rapport à la cellule 400 à 6 transistors, la cellule 500 comprend un transistor supplémentaire TDR1_{T} connecté entre le troisième transistor d'accès et la masse, et un autre transistor supplémentaire TDR1_{F}, connecté entre le quatrième transistor d'accès et la masse. Dans cet exemple, les troisième et quatrième transistors d'accès sont notés TAR3_{T}, TAR3_{F} et sont à double-grille symétrique, ce qui permet de limiter les courants de fuite. Les deux transistors supplémentaires, TDR_{T} et TDR_{F} peuvent être également dotés d'une double-grille symétrique. Dans cet exemple, les double-grilles du troisième transistor d'accès TAR_{T} et du quatrième transistor d'accès TAR_{F} sont contrôlés par la deuxième ligne de mot RWL. La double-grille du transistor TDR1_{T} supplémentaire est reliée au premier noeud de stockage T, tandis que la double-grille de l'autre transistor TDR1_{F} supplémentaire est reliée au deuxième noeud de stockage F.

Un exemple de fonctionnement de la cellule 500 est le suivant :
En mode lecture, les troisième et quatrième lignes de bit RBL_{T} et RBL_{F} sont préchargées à un potentiel VDD. Lorsque la deuxième ligne de mot RWL de la cellule 500 est activée, la troisième ligne de bit RBL_{T} se décharge via le troisième d'accès TAR3_{T} et le transistor TDR1_{T} tandis que la quatrième ligne de bit RBL_{F} est maintenue à un potentiel VDD du fait que le transistor TDR1_{F} est dans un état bloqué. Le fonctionnement en écriture de cette cellule 500 est semblable à celui de la cellule 400. En mode dit « standby » dans lequel il n'y a pas d'accès en écriture ou en lecture de la mémoire, pour limiter les courants de fuite des transistors TAR3_{T}, TAR3_{F}, TDR1_{T} et TDR1_{F}, les troisième et quatrième lignes de bit RBL_{T} et RBL_{F} peuvent être maintenues à la masse afin de développer une différence de potentiels entre le drain des transistors et la source de ces transistors nulle.

Les figures 16A à 16C illustrent des variantes de réalisation de la cellule 500 à 8 transistors qui vient d'être décrite.

Sur la figure 16A, un deuxième exemple de cellule 520 à 8 transistors est représenté, et diffère de la cellule 500 en ce qu'elle comporte un premier et un deuxième transistors d'accès TAW2_{T} et TAW2_{F} réalisés dans une technologie, par exemple PMOS, complémentaire de celle des transistors d'accès TAW1_{T} et TAW1_{F} de la cellule 500.

La cellule 520 à 8 transistors diffère également de la cellule 500 en ce qu'elle comporte deux transistors TD1_{T} et TD1_{F} réalisés dans une technologie, par exemple NMOS, complémentaire de celle des transistors TL1_{T} et TL1_{F} de la cellule 500.

Un exemple de tableau logique de fonctionnement de la cellule 520 est donné ci-dessous :

| | Rétention | Lecture | Ecriture |
|---|---|---|---|
| WWL | 1 | 1 | 0 |
| RWL | 0 | 1 | 0 |
| WBL | 1 | 1 | 0/1 |
| RBL | 0/1 | 1 | 0/1 |

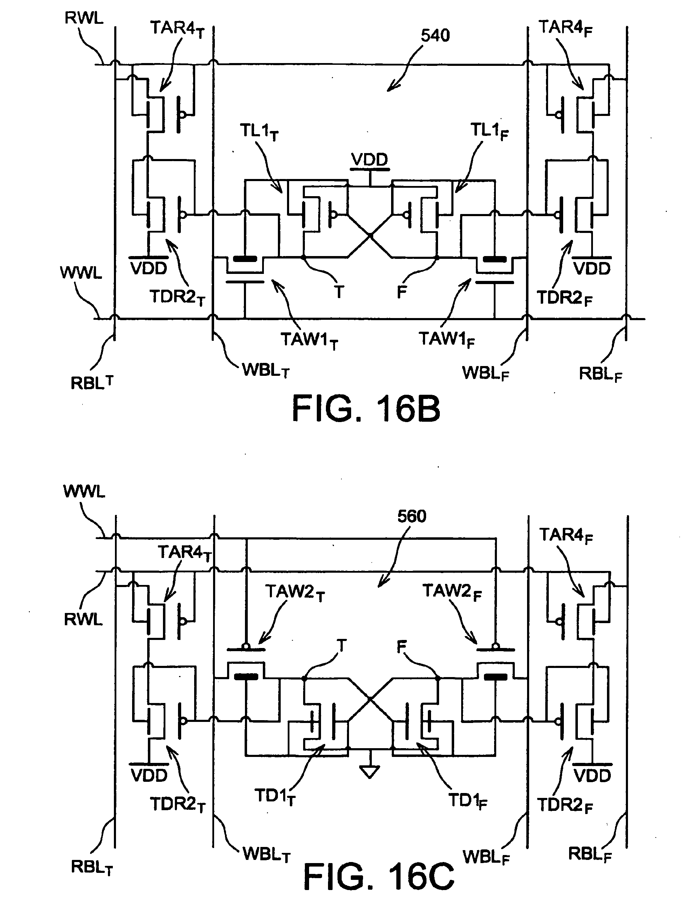

Sur la figure 16B, un troisième exemple de cellule 540 à 8 transistors est représentée. Cette cellule 540 diffère de la cellule 500 en ce que le troisième et quatrième transistors d'accès référencés TAR4_{T} et TAR4_{F} sont réalisés dans une technologie, par exemple PMOS, complémentaire de celle des transistors d'accès TAR3_{T} et TAR3_{F} de la cellule 500. La cellule 540 diffère également de la cellule 400 en ce qu'elle comporte deux transistors de conduction TD2_{T} et TD2_{F} réalisés dans une technologie, par exemple PMOS, complémentaire de celle des transistors TD1_{T} et TD1_{F} de la cellule 500.

Un exemple de tableau logique de fonctionnement de la cellule 540 est donné ci-dessous :

| | Rétention | Lecture | Ecriture |
|---|---|---|---|
| WWL | 0 | 0 | 1 |
| RWL | 1 | 0 | 1 |
| WBL | 0 | 0 | 0/1 |
| RBL | 0/1 | 0 | 0/1 |

Sur la figure 16C, un quatrième exemple de cellule à 8 transistors est donné. Cette cellule référencée 560, diffère de la cellule 540 précédemment décrite en ce qu'elle comporte un premier et un deuxième transistors d'accès TAW2_{T} et TAW2_{F} réalisés dans une technologie, par exemple PMOS, complémentaire de celle des premier et deuxième transistors des d'accès TAW1_{T} et TAW1_{F} de la cellule 540.

La cellule 560 diffère également de la cellule 540 en ce qu'elle comporte deux transistors de conduction TD1_{T} et TD1_{F} réalisés dans une technologie, par exemple NMOS, complémentaire de celle des transistors TL1_{T} et TL1_{F} de la cellule 540.

Un exemple de tableau logique de fonctionnement de la cellule 540 est donné ci-dessous :

| | Rétention | Lecture | Ecriture |
|---|---|---|---|
| WWL | 1 | 1 | 0 |
| RWL | 1 | 0 | 1 |
| WBL | 1 | 1 | 0/1 |
| RBL | 0/1 | 0 | 0/1 |

Une cellule (non représentée) à 8 transistors dotée chacun d'une double-grille asymétrique peut être également mise en oeuvre.

Des exemples comparatifs des performances des cellules 300, 400, 500 décrites précédemment, par rapport à celles d'une cellule à 6 transistors mis en oeuvre suivant l'art antérieur, dite « 6T standard », vont à présent être donnés. Ces résultats comparatifs ont été obtenus pour une technologie de 32 nm de dimension critique de grille, avec un potentiel d'alimentation VDD = 1V, une température T=27°C. Le dimensionnement des transistors dans chacune des cellules est donné dans le tableau ci-dessous, dans lequel :
- W_{L} et L_{L} désignent respectivement, la largeur et longueur des transistors de charge,
- W_{D} et L_{D} désignent respectivement les largeurs et longueur de transistors de conductions,
- W_{A} et L_{A} désignent respectivement les largeurs et longueur de transistors d'accès,
- W_{RA} et L_{RA} désignent respectivement les largeurs et longueur de transistors d'accès supplémentaires,
- W_{RD} et L_{RD} désignent respectivement les largeurs et longueur de transistors de conduction supplémentaires.

Pour la cellule 400 à 6 transistors et la cellule 500 à 8 transistors, le critère de stabilité a été atteint pour un dimensionnement avec une largeur de canal minimale Wₘᵢₙ = 76 nm, et une longueur de canal Lₘᵢₙ = 32 nm, des transistors de charge et de d'accès.

| **Géométrie (nm)** | **W_{L}** | **L_{L}** | **W_{D}** | **L_{D}** | **W_{A}** | **L_{A}** | **W_{RA}** | **L_{RA}** | **W_{RD}** | **L_{RD}** |
|---|---|---|---|---|---|---|---|---|---|---|
| 6T-stand. | 76 | 32 | 134 | 32 | 110 | 42 | - | - | - | - |
| Cellule 300 | 130 | 32 | - | - | 76 | 40 | - | - | - | - |
| Cellule 400 | 76 | 32 | - | - | 76 | 32 | 76 | 42 | - | - |
| Cellule 500 | 76 | 32 | - | - | 76 | 32 | 76 | 32 | 76 | 32 |

La cellule mémoire 300 à 4 transistors permet d'équilibrer la marge au bruit statique (SNM) et la marge au bruit en lecture (RNM) au dessus de 200 mV tout en conservant une densité élevée.

Comparée à une cellule 6T standard, la marge en écriture (WM) de la cellule 300 est améliorée de l'ordre de 68 % pour un gain en surface supérieur à 55 %. Les courants de fuite sont également améliorés de 9,5 % pour cette cellule 300 par rapport à la cellule 6T standard.

Les cellules 400 et 500 permettent d'approcher une marge au bruit statique SNM de l'ordre de 300 mV, soit 50 % supérieure à celle de la cellule 6T standard. Le dimensionnement minimal du coeur de ces cellules 400 et 500, permet d'améliorer de 74 % la marge en écriture. Dans un mode dans lequel il n'y a pas d'accès en lecture ou en écriture de la cellule ou dans le cas d'applications basse consommation, le courant I_{OFF} de fuite en rétention des cellules 400 et 500 est diminué de 28 % par rapport à la cellule 6T standard. La taille des transistors conduit à un dimensionnement des cellules inférieur d'au moins 25 % à celui de la cellule 6T standard. Les cellules 400 et 500 permettent d'obtenir un bon compromis entre les courants au courant de fuite des transistors d'accès (I_{PG}) et au courant de conduction de la cellule en mode lecture (I_{CELL}) ce qui se traduit par un facteur NBL, NBL étant égale au rapport (I_{CELL}/I_{PG}) augmenté de plus de 40 % par rapport à une cellule 6T standard.

### Documents cités

**[TAK01] :** K. Takeuchi, et al.,« A Study of Threshold voltage variation for Ultra SmallBulk and SOI CMOS », IEEE TED, VOL.48, No.9, September 2004.
**[YAM04] :** M. YAMAOKA, et al., « Low Power SRAM Menu for SOC Application Using Yin-Yang-Feedback memory Cell Technology », Symposium on VLSI circuits, Digest of Technical Papers, Honolulu, USA, June 2004.
**[KIM05] .** J. J. KIM, et al., « Back-Gate Controlled READ SRAM with Improved Stability », IEEE SOI CONFERENCE, pp. 211-212, Hawaii, USA, 2005.
**CHA'O1]** : [A. CHANDRAKASAN, et al., « Design of High-Performance Microprocessor Circuits », IEEE press, pp.285-308, FOX 2001*.*
**[CEA03] .** O. THOMAS, A. AMARA « Cellule mémoire statique à accès aléatoire (SRAM), et unité mémoire à ultra basse consommation réalisée à partir de telles cellules », Brevet Français, CEA-LETI, Avril 2003.
**[MOS02]** : W. LEUNG, et al., « High-Density ratio-Independent Four-Transistor RAM Cell Fabricated with Conventional Logic Process », US Patent N°6,442,060 B1, Monolithic System Technology, August 2002.
**[TI02] :** X. Deng, et al., « Loadless 4T SRAM cell with PMOS Drivers », US Patent, No. 0051379 A1, Texas Instruments, May 2002.

## Revendications

1. Cellule de mémoire vive à accès aléatoire, comprenant au moins une première pluralité de transistors (TL1_{T}, TL1_{F}, TD1_{T}, TD1_{F}, TL2_{T}, TL2_{F}) formant une bascule, au moins un premier transistor d'accès (TA1_{T}, TAW1_{T}) et au moins un deuxième transistor d'accès (TA1_{F}, TAW1_{F}) disposés respectivement entre une première ligne de bit (BL_{T}, WBL_{T}) et un premier noeud de stockage (T), et entre une deuxième ligne de bit (BL_{F}, WBL_{F}) et un deuxième noeud de stockage (F),
**caractérisée en ce que**
la première pluralité de transistors (TL1_{T}, TL1_{F}, TD1_{T}, TD1_{F}, TL2_{T}, TL2_{F}) sont des transistors à double-grille symétrique, le premier transistor d'accès (TA1_{T}, TAW1_{T}) et le deuxième transistor d'accès (TA1_{F}, TAW1_{F}) étant des transistors à double-grille asymétrique, une première grille du premier transistor d'accès (TA1_{T}, TAW1_{T}) et une première grille du deuxième transistor d'accès (TA1_{F}, TAW1_{F}) étant reliées à une première ligne de mot (WL, WWL) apte à acheminer un signal de polarisation, une seconde grille du premier transistor d'accès (TA1_{T}, TAW1_{T}) étant reliée au deuxième noeud de stockage (F) et une seconde grille du deuxième transistor d'accès étant reliée au premier noeud de stockage (T).

2. Cellule de mémoire vive à accès aléatoire selon la revendication 1, ladite première pluralité de transistors étant formée :
- d'un premier transistor de charge (TL1_{T}) à double-grille symétrique et d'un deuxième transistor de charge (TL1_{F}) à double-grille symétrique, les deux grilles du premier transistor de charge (TL1_{T}) étant connectées ensemble, les deux grilles du deuxième transistor de charge (TL1_{F}) étant également connectées ensemble,
ou
- d'un premier transistor de conduction (TD1_{T}) à double grille symétrique, et d'un deuxième transistor de conduction (TD1_{F}) à double grille symétrique, les deux grilles du premier transistor de conduction (TD1_{T}) étant connectées ensemble, les deux grilles du deuxième transistor de conduction (TD1_{F}) étant également connectées ensemble.

3. Cellule de mémoire vive à accès aléatoire, selon l'une des revendications 1 ou 2, comprenant en outre :
- au moins une deuxième ligne de mot (RWL),
- au moins une troisième et une quatrième lignes de bit (RBL_{T}, RBL_{F}),
- au moins un troisième et un quatrième transistors d'accès (TAR1_{T}, TAR1_{F}, TAR2_{T}, TAR2_{F}, TAR3_{T}, TAR3_{F}, TAR4_{T}, TAR4_{F}) à double-grille, connectés respectivement à la troisième ligne de bit (RBL_{T}) et à la quatrième ligne de bit (RBL_{F}).

4. Cellule de mémoire vive à accès aléatoire (RAM), selon la revendication 3, dans lequel une première grille du troisième transistor d'accès et une première grille du quatrième transistor d'accès sont reliées à la deuxième ligne de mot (RWL) apte à acheminer un signal de polarisation, une seconde grille du troisième transistor d'accès étant reliée au deuxième noeud de stockage (F) et une seconde grille du quatrième transistor d'accès étant reliée au premier noeud de stockage (T).

5. Cellule de mémoire vive à accès aléatoire, selon la revendication 4, dans lequel les deux grilles du troisième transistor d'accès (TAR3_{T}, TAR4_{T}) ou/et du quatrième transistor d'accès (TAR3_{F}, TAR4_{F}) sont connectées à la deuxième ligne de mot (RWL), la cellule comprenant en outre :
- au moins un transistor (TDR1_{T}) double-grille supplémentaire entre le troisième transistor d'accès (TAR3_{T}) et le premier noeud (T), les deux grilles dudit transistor (TDR1_{T}) supplémentaire étant connectées entre elles,
- au moins un autre transistor (TDR1_{F}) double-grille supplémentaire entre le quatrième transistor d'accès (TAR3_{F}) et le deuxième noeud (F), les deux grilles dudit autre transistor (TDR1_{F}) supplémentaire étant connectées entre elles.

6. Cellule de mémoire vive à accès aléatoire selon la revendication 5, les transistors double-grille supplémentaires étant dotés respectivement d'une double-grille symétrique.

7. Cellule de mémoire vive à accès aléatoire (RAM) selon l'une des revendications 1 à 6, lesdites double-grilles asymétriques étant formées d'au moins un premier bloc de grille et d'au moins un deuxième bloc de grille de part et d'autre d'une zone semi-conductrice active, le premier bloc de grille, la zone semi-conductrice active, le deuxième bloc de grille étant superposés sur un substrat.

8. Cellule de mémoire vive à accès aléatoire (RAM) selon l'une des revendications 1 à 7, lesdites double-grilles asymétriques étant formées d'au moins un premier bloc de grille et d'au moins un deuxième bloc de grille de part et d'autre d'une zone semi-conductrice active, le premier bloc de grille zone semi-conductrice active, le deuxième bloc de grille étant juxtaposés sur un substrat.

9. Cellule de mémoire vive à accès aléatoire selon l'une des revendications 7 ou 8, ledit premier bloc de grille ayant une dimension critique donnée, ledit deuxième bloc de grille ayant une dimension critique différente de ladite dimension critique donnée.

10. Cellule de mémoire vive à accès aléatoire selon l'une des revendications 7 à 9, le premier bloc de grille étant séparé de la zone active semi-conductrice par un premier bloc de matériau diélectrique d'épaisseur donnée, le deuxième bloc de grille étant séparé de la zone active semi-conductrice par un deuxième bloc de matériau diélectrique d'épaisseur supérieure à l'épaisseur donnée.

11. Cellule de mémoire vive à accès aléatoire (RAM) selon l'une des revendications 7 à 10, lesdites double-grille asymétriques étant formées respectivement d'un premier bloc de grille de composition donnée et d'un deuxième bloc de grille de composition différente de la composition donnée.

12. Cellule de mémoire vive à accès aléatoire (RAM) selon l'une des revendications 1 à 11, le deuxième bloc appartenant à ladite seconde grille, le premier bloc appartenant à ladite première grille.

13. Mémoire, comprenant une pluralité de cellules suivant l'une des revendications 1 à 12.

14. Dispositif microélectronique de mémoire, comprenant une mémoire SRAM selon la revendication 13.

## Claims

1. Random access memory cell comprising at least a first plurality of transistors (TL1_{T}, TL1_{F}, TD1_{T}, TD1_{F}, TL2_{T}, TL2_{F}) forming a flip-flop, at least a first access transistor (TA1_{T}, TAW1_{T}) and at least a second access transistor (TA1_{F}, TAW1_{F}) disposed respectively between a first bit line (BL_{T}, WBL_{T}) and a first storage node (T), and between a second bit line (BL_{F}, MBL_{F}) and a second storage node (F),
**characterised in that** the first plurality of transistors (TL1_{T}, TL1_{F}, TD1_{T}, TD1_{F}, TL2_{T}, TL2_{F}) are asymmetric dual-gate transistors, the first access transistor (TA1_{T}, TAW1_{T}) and the second access transistor (TA1_{F}, TAW1_{F}) being asymmetric dual-gate transistors, a first gate of the first access transistor (TA1_{T}, TAW1_{T}) and a first gate of the second access transistor (TA1_{F}, TAW1_{F}) being connected to a first word line (WL, WWL) able to route a biasing signal, a second gate (TA1_{F}, TAW1_{F}) of the first access transistor being connected to the second storage node (F) and a second gate of the second access transistor being connected to the first storage node (T).

2. Random access memory cell according to claim 1, said first plurality of transistors being formed by:
- a first symmetrical dual-gate load transistor (TL1_{T}) and a second symmetrical dual-gate load transistor (TL1_{F}), the two gates of the first load transistor (TL1_{T}) being connected together, the two gates of the second load transistor (TL1_{F},) also being connected together,
or
- a first symmetrical dual-gate conduction transistor (TD1_{T}) and a second symmetrical dual-gate conduction transistor (TD1_{F}), the two gates of the first conduction transistor (TD1_{T}) being connected together, and the two gates of the second conduction transistor (TD1_{F}) also being connected together.

3. Random access memory cell according to one of claims 1 or 2, also comprising:
- at least a second word line (RWL),
- at least third and fourth bit lines (RBL_{T}, RBL_{F}),
- at least third and fourth dual-gate access transistors (TAR1_{T}, TAR1_{F}, TAR2_{T}, TAR2_{F}, TAR3_{T}, TAR3_{F}, TAR4_{T}, TAR4_{F}) connected respectively to the third bit line (RBL_{T}) and to the fourth bit line (RBL_{F}).

4. Random access memory cell (RAM) according to claim 3, in which a first gate of the third access transistor and a first gate of the fourth access transistor are connected to the second word line (RWL) able to route a biasing signal, a second gate of the third access transistor being connected to the second storage node (F) and a second gate of the fourth access transistor being connected to the first storage node (T).

5. Random access memory cell according to claim 4, in which the two gates of the third access transistor (TAR3_{T}, TAR4_{T}) and/or of the fourth access transistor (TAR3_{F}, TAR4_{F}) are connected to the second word line (RWL), the cell also comprising:
- at least one additional dual-gate transistor (TDR1_{T}) between the third access transistor (TAR3_{T}) and the first node (T), the two gates of said third additional transistor (TDR1_{T}) being connected to each other,
- at least one other additional dual-gate transistor (TDR1_{F}) between the fourth access transistor (TAR3_{F}) and the second node (F), the two gates of said other additional transistor (TDR1_{F}) being connected to each other.

6. Random access memory cell according to claim 5, the additional dual-gate transistors being provided respectively with a symmetrical dual gate.

7. Random access memory cell (RAM) according to one of claims 1 to 6, said asymmetric dual gates being formed by at least a first gate block and at least a second gate block on each side of an active semiconductor zone, the first gate block, the active semiconductor zone and the second gate block being superimposed on a substrate.

8. Random access memory cell (RAM) according to one of claims 1 to 7, said asymmetric dual gates being formed by at least a first gate block and at least a second gate block on each side of an active semiconductor zone, the first active semiconductor zone gate block, the second gate block being juxtaposed on a substrate.

9. Random access memory cell according to one of claims 7 or 8, said first gate block having a given critical dimension, said second gate block having a critical dimension different from said given critical dimension.

10. Random access memory cell according to one of claims 7 to 9, the first gate block being separated from the semiconductor active zone by a first block of dielectric material of given thickness, the second gate block being separated from the semiconductor active zone by a second block of dielectric material with a thickness greater that the given thickness.

11. Random access memory cell (RAM) according to one of the claims 7 to 10, said asymmetric dual gates being formed respectively by a first gate block of given composition and a second gate block with a composition different from the given composition.

12. Random access memory cell (RAM) according to one of claims 1 to 11, the second block belonging to said second gate, the first block belonging to said first gate.

13. Memory, comprising a plurality of cells according to one of claims 1 to 12.

14. Microelectronic memory device comprising an SRAM memory according to claim 13.

## Patentansprüche

1. Aktive Speicherzelle mit wahlfreiem Zugriff, umfassend:
- wenigstens eine erste Mehrzahl von eine Kippschaltung bildenden Zugangs- bzw. Zugriffstransistoren (TL1_{T}, TL1_{F}, TD1_{T}, TD1_{F}, TL2_{T}, TL2_{F})
- wenigstens einen ersten Zugangs- bzw. Zugriffstransistor (TA1_{T}, TAW1_{T}) und wenigstens einen zweiten Zugangs- bzw. Zugriffstransistor (TA1_{F}, TAW1_{F}), die beziehungsweise zwischen einer ersten Bit-Leitung (BL_{T}, WBL_{T}) und einem ersten Speicherknoten (T) sowie zwischen einer zweiten Bit-Leitung (BL_{F}, WBL_{F}) und einem zweiten Speicherknoten (F) angeordnet sind,
**dadurch gekennzeichnet dass**
- die erste Mehrzahl Zugangs- bzw. Zugriffstransistoren (TL1_{T}, TL1_{F}, TD1_{T}, TD1_{F}, TL2_{T}, TL2_{F}) Transistoren mit asymmetrischem Doppelgate sind,
- der erste Zugangs- bzw. Zugriffstransistor (TA1_{T}, TAW1_{T}) und der zweite Zugangs- bzw. Zugriffstransistor (TA1_{F}, TAW1_{F}) Transistoren mit asymmetrischem Doppelgate sind,
ein erstes Gate des ersten Zugriffstransistors (TA1_{T}, TAW1_{T}) und ein erstes Gate des zweiten Zugriffstransistors (TA1_{F}, TAW1_{F}) mit einer ersten Wortleitung (WL, WWL) zur Zufuhr eines Vorspannsignals verbunden sind, und ein zweites Gate des ersten Zugriffstransistors (TA1_{T}, TAW1_{T}) mit dem zweiten Speicherknoten (F) sowie ein zweites Gate des zweiten Zugriffs-Transistors mit dem ersten Speicherknoten (T) verbunden sind.

2. Aktive Speicherzelle mit wahlfreiem Zugriff nach Anspruch 1, bei der die genannte erste Mehrzahl von Transistoren gebildet wird von:
- einem ersten Ladetransistor (TL1_{T}) mit symmetrischem Doppel-Gate und von einem zweiten Ladetransistor (TL1_{F}) mit symmetrischem Doppel-Gate, wobei die beiden Gates des ersten Ladetransistors (TL1_{T}) miteinander verbunden sind und die beiden Gates des zweiten Ladetransistors (TL1_{F}) gleichfalls miteinander verbunden sind;
oder
- von einem ersten Leitungstransistor (TD1_{T}) mit symmetrischem Doppel-Gate und von einem zweiten Leitungstransistor (TD1_{F}) mit symmetrischem Doppel-Gate, wobei die beiden Gates des ersten Leitungstransistors (TD1_{T}) mit einander verbunden sind und die beiden Gates des zweiten Leitungstransostors (TD1_{F}) ebenfalls mit einander verbunden sind.

3. Aktive Speicherzelle mit wahlfreiem Zugriff, nach einem der Ansprüche 1 oder 2, welche des Weiteren umfasst:
- wenigstens eine zweite Wortleitung (RWL),
- wenigstens eine dritte und eine vierte Bitleitung (RBL_{T}, RBL_{F}),
- wenigstens einen dritten und einen vierten Zugriffstransistor (TAR1_{T}, TAR1_{F}, TAR2_{T}, TAR2_{F}, TAR3_{T}, TAR3_{F}, TAR4_{T}, TAR4_{F}) mit Doppel-Gate, die jeweils mit der dritten Bit-Leitung (RBL_{T}) beziehungsweise mit der vierten Bit-Leitung (RBL_{F}) verbunden sind.

4. Aktive Speicherzelle mit wahlfreiem Zugriff (RAM), nach Anspruch 3, bei welcher ein erstes Gate des dritten Zugriffstransistors und ein erstes Gate des vierten Zugriffstransistors mit der zweiten Wortleitung (RWL) zur Zufuhr eines Vorspannsignals verbunden sind, und bei dem ein zweites Gate des dritten Zugriffstransistors mit dem zweiten Speicherknoten (F) und ein zweites Gate des vierten Zugriffstransistors mit dem ersten Speicher knoten (T) verbunden sind.

5. Aktive Speicherzelle mit wahlfreiem Zugriff, nach Anspruch 4, bei welcher die beiden Gates des dritten Zugriffstransistors (TAR3_{T}, TAR4_{T}) und/oder des vierten Zugriffstransistors (TAR3_{F}, TAR4_{F}) mit der zweiten Wortleitung (RWL) verbunden sind und bei welcher die Zelle des weiteren umfasst:
- wenigstens einen zusätzlichen DoppelGate-Transistor (TDR1_{T}) zwischen dem dritten Zugriffstransistor (TAR3_{T}) und dem ersten Knoten (T), wobei die beiden Gates des genannten zusätzlichen Transistors (TDR1_{T}) mit einander verbunden sind,
- wenigstens einen anderen zusätzlichen Doppel-Gate-Transistor (TDR1_{F}) zwischen dem vierten Zugriffstransistor (TAR3_{F}) und dem zweiten Knoten (F) und bei welcher die beiden Gates des anderen zusätzlichen Transistors (TDR1_{F}) unter einander verbunden sind.

6. Aktive Speicherzelle mit wahlfreiem Zugriff, nach Anspruch 5, bei welcher die zusätzlichen Doppel-Gate-Transistoren jeweils mit einem symmetrischen Doppelgate versehen sind.

7. Aktive Speicherzelle mit wahlfreiem Zugriff (RAM), nach einem der Ansprüche 1 bis 6, bei welcher die genannten asymmetrischen Doppelgates durch wenigstens einen ersten Gateblock und durch wenigstens einen zweiten Gateblock zu beiden Seiten einer aktiven Halbleiter-Zone gebildet werden und der erste Gateblock, die aktive Halbleiter-Zone und der zweite Gateblock auf einem Substrat übereinander angeordnet sind.

8. Aktive Speicherzelle mit wahlfreiem Zugriff (RAM) nach einem der Ansprüche 1 bis 7, bei welcher die genannten asymmetrischen Doppelgates von wenigstens einem ersten Gateblock und von wenigstens einem zweiten Gateblock zu beiden Seiten einer aktiven Halbleiterzone gebildet werden und der erste Gateblock, die aktive Halbleiterzone und der zweite Gateblock auf einem Substrat nebeneinander gegen-überstehend angeordnet sind.

9. Aktive Speicherzelle mit wahlfreiem Zugriff, nach einem der Ansprüche 7 oder 8, bei welcher der genannte erste Gateblock eine gegebene kritische Abmessung und der genannte zweite Gateblock eine von dieser genannten kritischen Abmessung verschiedene kritische Abmessung besitzen.

10. Aktive Speicherzelle mit wahlfreiem Zugriff, nach einem der Ansprüche 7 bis 9, bei welcher der erste Gateblock von der aktiven Halbleiterzone durch einen ersten Block vorgegebener Dicke aus einem dielektrischen Material getrennt ist und bei welcher der zweite Gateblock von der aktiven Halbleiterzone durch einen Block aus einem dielektrischen Material getrennt ist, dessen Dicke größer als die genannte vorgegebene Dicke ist.

11. Aktive Speicherzelle mit wahlfreiem Zugriff (RAM), nach einem der Ansprüche 7 bis 10, bei welcher die genannten asymetrischen Doppelgates durch einen ersten Gateblock gegebener Zusammensetzung und durch einen zweiten Gateblock einer von der gegebenen Zusammensetzung verschiedenen Zusammensetzung gebildet werden.

12. Aktive Speicherzelle mit wahlfreiem Zugriff (RAM), nach einem der Ansprüche 1 bis 11, bei welcher der zweite Block zu dem genannten zweiten Gate und der erste Block zu dem genannten ersten Gate gehören.

13. Speicher, welcher eine Mehrzahl von Zellen gemäß einem der Ansprüche 1 bis 12 umfasst.

14. Mikroelektronische Speichervorrichtung, welche einen SRAM-Speicher gemäß Anspruch 13 aufweist.
